# EUROPÄISCHE PATENTANMELDUNG

(11) **EP 1 478 216 A1**
(43) Veröffentlichungstag der Anmeldung: **17.11.2004**
(21) Anmeldenummer: 03010755.1
(22) Anmeldetag: 14.05.2003
(51) Int. Cl.: H05K 3/40

(54) **Verfahren zur Herstellung einer Trägerplatte für elektrische Schaltungen**

(71) Anmelder: A.B. Mikroelektronik Gesellschaft mit beschränkter Haftung, 5020 Salzburg (AT)
(72) Erfinder: Wilczek, Klaus Peter, 83404 Ainring (DE)
(74) Vertreter: Hofinger, Stephan

(57) **Zusammenfassung**

Verfahren zur Herstellung einer Trägerplatte für elektrische Schaltungen, bei dem auf einer nichtleitenden Grundplatte (1), insbesondere aus Al₂O₃ oder AlN, auf der Oberund Unterseite Kupferfolien (2, 3) aufgebracht werden, wobei vor dem Aufbringen der Kupferfolien (2, 3) die Grundplatte (1) mit Löchern (4) versehen wird, in die eine Kupferteilchen enthaltende Paste (5) eingebracht wird, die vor dem Aufbringen der Kupferfolien (2, 3) ausgehärtet wird sowie mittels dieses Verfahrens hergestellte Trägerplatte.

## Beschreibung

Die vorliegende Erfindung betrifft ein Verfahren zur Herstellung einer Trägerplatte für elektrische Schaltungen, wobei auf einer nichtleitenden Grundplatte, insbesondere aus Al₂O₃ oder AIN, auf der Ober- und Unterseite Kupferfolien aufgebracht werden, sowie die mittels dieses Verfahrens hergestellte Trägerplatte.

Es ist bereits bekannt, nichtleitende Grundplatten, insbesondere aus Al₂O₃ oder AIN, mit einer Kupferfolie zu versehen, in die anschließend Strukturen eingeätzt werden, um Leiterbahnen und Anschlussstellen zu erzeugen. Beim Verbinden der Kupferfolie mit der Trägerplatte wird ausgenützt, dass Kupfer unter dem Einfluss von Sauerstoff eine etwas reduzierte eutektische Schmelztemperatur aufweist, sodass sich bei entsprechend gezielter Erhitzung die Grenzschicht der Kupferfolie zur Grundplatte erweicht, verflüssigt und mit dieser verbindet, wogegen die restliche Kupferfolie fest bleibt.

Um zu vermeiden, dass sich die Trägerplatte unter Wärmeeinfluss verbiegt, wird üblicherweise auf beiden Seiten der Grundplatte eine Kupferfolie aufgebracht, sodass sich ein symmetrischer Aufbau ergibt. In diesem Zusammenhang bestehen Bestrebungen, die primär aus statischen Überlegungen aufgebrachte Kupferfolie auf der Gegenseite ebenfalls für elektrische Schaltungen zu nutzen. Dazu ist es notwendig, eine leitende Verbindung zwischen den Kupferfolien durch die Grundplatte hindurch herzustellen.

Bekannt geworden ist diesbezüglich eine Methode, die vorsieht, in Löcher in der Grundplatte Kupferkugeln einzusetzen. Problematisch bei dieser Methode ist es, dass die Kupferkugeln im Durchmesser genau mit der Stärke der Grundplatte übereinstimmen müssen. Ist der Durchmesser der Kupferkugeln zu klein, entsteht kein elektrischer Kontakt, ist er zu groß, entstehen in den anschließend aufgelegten Kupferfolien Aufwölbungen, die ein präzises Einätzen von Leiterbahnen beeinträchtigen. Darüber hinaus muss der Lochdurchmesser genau an die Kupferkugeln angepasst werden, will man eine zusätzliche Fixierung der Kupferkugeln während der Verarbeitung vermeiden. Dies bedeutet letztlich, dass die Methode auf einen bestimmten Lochdurchmesser beschränkt ist.

Aufgabe der Erfindung ist es, in diesem Zusammenhang ein Verfahren anzubieten, mit dem auf einfache Weise unterschiedlich große Löcher, insbesondere auch Löcher mit kleinem Durchmesser, in einer Grundplatte durchkontaktiert werden können.

Das erfindungsgemäße Verfahren sieht dazu vor, dass vor dem Aufbringen der Kupferfolien die Grundplatte mit Löchern versehen wird, in die eine Kupferteilchen enthaltende Paste eingebracht wird, die vor dem Aufbringen der Kupferfolien ausgehärtet wird.

Erzielt wird auf dieser Weise eine Trägerplatte, für elektrische Schaltungen, wobei auf einer nichtleitenden Grundplatte, insbesondere aus Al₂O₃ oder AIN, auf der Ober- und Unterseite Kupferfolien aufgebracht sind und wobei in der Grundplatte vorgesehene Löcher zumindest teilweise mit einer ausgehärteten (gesinterten), Kupferteilchen enthaltenden Paste gefüllt sind.

Mit dem erfindungsgemäßen Verfahren kann rasch in einer Vielzahl von Löchern ein elektrischer Kontakt hergestellt werden, ohne dass die Zahl der Löcher die Kosten erheblich beeinflusst. Zudem ist die Wahl der Lochdurchmesser beliebig. Dies erweist sich insbesondere dann von Vorteil, wenn abgesehen von elektrisch funktionalen Löchern in der Grundplatte weitere Löcher vorgesehen werden, um Wärme durch die Trägerplatte abzuleiten. In diesem Fall sind besonders große Löcher, die in großer Zahl eng beieinander liegen und weitgehend mit gesinterter Kupferpaste gefüllt sind, zur Überbrückung der eine thermische Barriere bildenden Grundplatte günstig.

Die Löcher in der Grundplatte lassen sich besonders rationell mittels Laser erzeugen.

Als wirtschaftliche Methode zum Aufbringen der Paste hat sich Siebdruck oder automatisches Dispensen bewährt.

Enthält die Paste mindestens ein Oxyd als Bindemittel, wird sichergestellt, dass beim anschließenden Aufbringen der Kupferfolien eine Verschmelzung der ausgehärteten (gesinterten) Kupferpaste mit den Kupferfolien stattfindet. Dadurch wird die elektrische Leitfähigkeit optimiert.

Zusätzlich enthaltenes Glaspulver erhöht die Haftung der Kupferpaste in den Löchern.

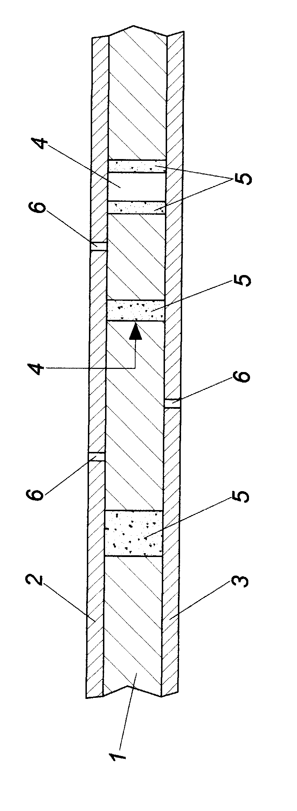

Weitere Merkmale und Einzelheiten der vorliegenden Erfindung werden anschließend anhand der Zeichnung, die eine Trägerplatte im Schnitt zeigt, näher erläutert.

Die erfindungsgemäße Trägerplatte für elektrische Schaltungen weist im Kern eine keramische Grundplatte 1 auf, die vorzugsweise aus Al₂O₃ oder AIN besteht. Diese Grundplatte 1 werden an jenen Stellen, an denen entweder eine elektrische oder eine thermische Brücke zwischen Ober- und Unterseite der Grundplatte 1 erwünscht ist, mittels Laser oder einem anderen geeigneten Verfahren Löcher 4 erzeugt.

Die Löcher 4 werden anschließend mit einer Kupferteilchen enthaltenden Paste 5 mittels Siebdruck und Vakuumdurchkontaktierung oder automatischem Dispensen zumindest teilweise gefüllt. Eine vollständige Füllung ist nicht notwendig, solange eine durchgehende elektrische Verbindung von der Oberseite zur Unterseite entsteht, wie dies beim rechtesten Loch 4 in der Zeichnung dargestellt ist.

Die Paste 5 enthält etwa 75 Gewichts-% Kupferpulver mit einer durchschnittlichen Teilchengröße von 3 µ. Darüber hinaus sind Glaspulver sowie Zinkoxyd, Siliziumoxyd oder Kupferoxyd als Bindemittel vorgesehen. Als organisches Lösungsmittel, das der Paste 5 die gewünschte Viskosität verleiht, kann beispielsweise eine 5 %-ige Lösung von Ethylzellulose in Texanol verwendet werden.

Im nächsten Arbeitsschritt wird die Paste 5 in den Löchern 4 in der Grundplatte 1 bei Temperaturen bis zu 900 °C unter N₂ ausgehärtet (gesintert).

Das anschließende Aufbringen der Kupferfolien 2 und 3 erfolgt bei einer Temperatur von etwa 1065 °C, bei der die Randschicht der Kupferfolien 2 und 3 durch den Einfluss des Sauerstoffs aus der Al₂O₃-Grundplatte oder zusätzlich zugeführten Sauerstoff vorzeitig flüssig wird, wogegen die restliche Kupferfolie noch fest bleibt. Somit entsteht zwischen den Kupferfolien 2 und 3 und der Grundplatte 1 eine feste Verbindung. Da auch die Paste 5 Oxyde enthält, entsteht auch im Bereich der mit Paste 5 gefüllten Löcher 4 eine Verschmelzung.

In die Kupferfolien 2 und 3 können schließlich auf beiden Seiten der Trägerplatte Kanäle 6 geätzt werden, die eine bestimmte Leiterbahnstruktur erzeugen.

## Patentansprüche

1. Verfahren zur Herstellung einer Trägerplatte für elektrische Schaltungen, bei dem auf einer nichtleitenden Grundplatte (1), insbesondere aus Al₂O₃ oder AIN, auf der Ober- und Unterseite Kupferfolien (2, 3) aufgebracht werden, wobei vor dem Aufbringen der Kupferfolien (2, 3) die Grundplatte (1) mit Löchern (4) versehen wird, **dadurch gekennzeichnet, dass** in die Löcher (4) eine Kupferteilchen enthaltende Paste (5) eingebracht wird, die vor dem Aufbringen der Kupferfolien (2, 3) ausgehärtet wird.

2. Verfahren nach Anspruch 1, **dadurch gekennzeichnet, dass** die Löcher (4) mittels Laser erzeugt oder gestanzt werden.

3. Verfahren nach Anspruch 1 oder 2, **dadurch gekennzeichnet, dass** die Paste (5) mittels Siebdruck oder Dispenser aufgebracht wird.

4. Verfahren nach einem der Ansprüche 1 bis 3, **dadurch gekennzeichnet, dass** die Paste (5) bei Temperaturen bis zu 900 °C ausgehärtet (gesintert) wird.

5. Verfahren nach einem der Ansprüche 1 bis 4, **dadurch gekennzeichnet, dass** die Kupferfolien (2, 3) bei der eutektischen Schmelztemperatur von Kupfer unter dem Einfluss von Sauerstoff von etwa 1065 °C, jedenfalls unter 1083 °C, mit der Grundplatte (1) sowie der Paste (5) in den Löchern (4) verbunden werden.

6. Trägerplatte für elektrische Schaltungen, wobei auf einer nichtleitenden Grundplatte (1), inbesondere aus Al₂O₃ oder AIN, auf der Ober- und Unterseite Kupferfolien (2, 3) aufgebracht sind und wobei die Grundplatte Löcher aufweist, **dadurch gekennzeichnet, dass** die Löcher (4) zumindest teilweise mit einer ausgehärteten (gesinterten), Kupferteilchen enthaltenden Paste gefüllt sind.

7. Trägerplatte nach Anspruch 6, **dadurch gekennzeichnet, dass** die Löcher (4) von den Kupferfolien (2, 3) abgedeckt sind.

8. Trägerplatte nach Anspruch 6 oder 7, **dadurch gekennzeichnet, dass** die Kupferfolien (2, 3) plane Außenflächen aufweisen.

9. Trägerplatte nach einem der Ansprüche 6 bis 8, **dadurch gekennzeichnet, dass** die Paste (5) über 50 Gewichts-% Kupferteilchen enthält.

10. Trägerplatte nach einem der Ansprüche 6 bis 9, **dadurch gekennzeichnet, dass** die Paste (5) ein organisches Lösungsmittel enthält.

11. Trägerplatte nach einem der Ansprüche 6 bis 10, **dadurch gekennzeichnet, dass** die Paste (5) als Bindemittel mindestens ein Oxyd enthält.

12. Trägerplatte nach Anspruch 11, **dadurch gekennzeichnet, dass** das Oxyd Zinkoxyd, Siliziumoxyd oder Kupferoxid ist.

13. Trägerplatte nach Anspruch 11 oder 12, **dadurch gekennzeichnet, dass** die Paste (5) als Bindemittel zusätzlich Glaspulver enthält.

14. Trägerplatte nach einem der Ansprüche 6 bis 13, **dadurch gekennzeichnet, dass** die Grundplatte (1) eine Vielzahl von eng nebeneinander liegenden Löchern (4) aufweist, die alle weitgehend mit gehärteter (gesinterter) Paste (5) gefüllt sind.
